# EUROPÄISCHE PATENTSCHRIFT

(11) **EP 0 337 333 B1**
(45) Veröffentlichungstag und Bekanntmachung des Hinweises auf die Patenterteilung: **18.08.1993**
(21) Anmeldenummer: 89106245.7
(22) Anmeldetag: 08.04.1989
(51) Int. Cl.: C23G 1/00

(54) **Verfahren zum Behandeln benutzter und verunreinigter elektronischer und elektromechanischer Bauteile**
Process for treating used and soiled electronical or electromechanical parts
Procédé de traitement de pièces électroniques ou électromécaniques, utilisées et souillées

(30) Priorität: 09.04.1988 DE 3811927
(43) Veröffentlichungstag der Anmeldung: 18.10.1989
(73) Patentinhaber: Henkel Kommanditgesellschaft auf Aktien, 40191 Düsseldorf (DE)
(72) Erfinder: Schmitz, Rudolf, . (DE)

(56) Entgegenhaltungen:
- EP-A- 0 006 017
- CHEMICAL ABSTRACTS, Band 104, Nr. 10, März 1986, Columbus, OH (US); Seite 254, Nr. 72907q*

## Beschreibung

Die Erfindung betrifft ein Verfahren zum Behandeln benutzter und verunreinigter elektronischer und elektromechanischer Bauteile, insbesondere deren metallischer Komponenten, wobei die Verunreinigungen der Bauteile in einem Tauchbad durch ein wäßriges Reinigungsmittel zumindest angelöst werden.

Als Reinigungsmittel wird dazu beispielsweise das im Handel unter der Warenbezeichnung Lixton-Konzentrat erhältliche Mittel verwendet.

Bei elektronischen und elektromechanischen Bauteilen, wie sie beispielsweise in Luftfahrtgeräten Einsatz finden, besteht dauernd die Gefahr der Bildung von Verunreinigungen, die aus der Luft aufgenommen werden. Beispielsweise können die für das Betreiben der elektronischen Einrichtungen erforderlichen Belüftungen, selbst wenn Kapselung und Filterung vorgesehen ist, nicht verhindern, daß solche Verunreinigungen sich an den elektronischen oder elektromechanischen Bauteilen ablagern. Solche wachsenden Verunreinigungen stören die Funktion und führen dazu, daß die Bauteile auszutauschen sind. Zwar begrenzt das im Handel erhältliche, obengenannte Reinigungsmittel schon im gewissen Maße für eine bestimmte Zeitdauer eine neue Korrosionsbildung, kann diese jedoch nicht wirksam über eine längere Zeitdauer verhindern. Der Inhibierungseffekt ist nämlich, bedingt durch die Eigenschaften des Emulsionskaltreinigers, nur temporär. Da durch Verschmutzung und Korrosion Leitungsbrücken im Bauteil entstehen, bzw. Kontaktstellen unterbrochen werden können, besteht Interesse, diese Oberflächen zu schützen und vor Zerstörung durch korrosive Zersetzung zu bewahren. Darüber hinaus sind die Folgen etwaiger Fehlfunktion des Bauteils nur im Einzelfall abzuschätzen, können jedoch, - wie etwa in Computerbauteilen zur Steuerung von Luftfahrzeugen - beträchtliche Schäden hervorzurufen. Das im Handel erhältliche oben genannte Reinigungsmittel schützt nur temporär vor Korrosion, da ein Hydrophobierungseffekt im wäßrigen Medium, wie Lixton-Konzentrat wasserverdünnt, nur begrenzt möglich ist.

Da die verwendeten elektronischen Bauteile teuer sind, besteht ein natürliches Interesse, deren Lebensdauer zu erhöhen und die Wartungsintervalle zu verlängern.

Hiervon ausgehend liegt der Erfindung die Aufgabe zugrunde, ein Verfahren zum Behandeln solcher verunreinigter elektronischer und elektromechanischer Bauteile vorzuschlagen, welches einen möglichst langen, störungsfreien Einsatz solcher Bauteile gewährleistet und damit die Lebensdauer erhöht sowie mögliche Fehlimpulse oder Versagen während des Betriebes weitestgehend ausschaltet.

In der EP-A-0 006 017 wird ein Verfahren zur Reinigung und antikorrosiven Behandlung von metallischen Bauteilen, insbesondere Automobil-Karosserien, beschrieben. Im ersten Verfahrensschritt werden die Bauteile mit einer wäßrigen. Reinigungslösung, die einen Fett-Emulgator enthält, behandelt. Es folgt eine Spülung der Bauteile mit Wasser. Im nächsten Schritt wird auf die Bauteile ein antikorrosives Mittel zum Entfernen von Rost aufgesprüht. Derartige Mittel basieren vorzugsweise auf wäßrigen Lösungen, die Citronensäure, einen Fett-Emulgator und einen Korrosionsinhibitor (ARMOHIB^{R}25) enthalten. Vorzugsweise werden die Bauteile anschließend erneut mit Wasser gespült und getrocknet.

Demgegenüber betrifft die Erfindung ein Verfahren zum Behandeln benutzter und verunreinigter elektronischer und elektromechanischer Bauteile, insbesondere deren metallischer Komponenten, wobei die Verunreinigungen der Bauteile in einem Tauchbad durch ein wäßriges Reinigungsmittel zumindest angelöst werden, welches dadurch gekennzeichnet ist, daß die Bauteile in einem zweiten Schritt mit Wasser abgespült und danach in einem dritten Schritt mit Luft, insbesondere Druckluft, abgeblasen werden, daß in einem vierten Schritt die Bauteile mit einem wasserverdrängenden Mittel behandelt, insbesondere mit Druck abgesprüht oder getaucht werden, und anschließend die Bauteile in einem fünften Schritt im warmen Luftstrom getrocknet werden, und daß danach in einem sechsten Schritt auf die metallischen Bauteile ein Korrosionsschutzmittel, bestehend aus einem Gemisch aus paraffinischen, naphthenischen, nicht-halogenierten Kohlenwasserstoffen mit einem Aromatengehalt kleiner 0,5 Gew.-% sowie in paraffinischen Mineralölen gelösten Korrosionsinhibitoren, ausgewählt aus Fettsäureestern des Sorbinalkohols (2,4-Hexadien-1-ol), durch Tauchen, Sprühen oder Auftragen aufgebracht wird.

Die durch die wäßrige Lösung von polaren Verschmutzungen (Salzablagerungen) befreite Oberfläche, wird im vierten Schritt durch die Behandlung mit einem aprotischen und apolaren Lösemittelgemisch, unter Zusatz von Tensiden von unpolaren Substanzen (Fetten, Ölen) befreit und hydrophobiert. Die so vorbehandelte Oberfläche wird daraufhin mit einem Korrosionsschutzmittel konserviert. Diese Behandlung gewährleistet einen dauerhaften Schutz. In weiterer Ausgestaltung des erfindungsgemäßen Verfahrens ist vorgesehen, daß bei starkem Korrosionsbefall ein Zwischenschritt zur Entfernung bestehender Korrosionsschäden eingefügt werden kann. Hierzu können nach dem zweiten Reinigungsschritt, d.h. nach dem Abspülen der Bauteile mit Wasser, aber vor dem Abblasen mit Luft, die Korrosionsprodukte oxidativ entfernt werden. Um eine Schädigung des Umfeldes weitgehend zu vermeiden, ist diese Behandlung auf korrosionsbefallene Oberflächenbereiche zu begrenzen. Die oxidative Entfernung erfolgt durch wasserverdünnte Phosphorsäure. Entsprechend des Oberflächenzustandes wird der Korrosionsentferner nach der Einwirkungszeit durch Abspülen mit Wasser entfernt.

Zur Behandlung der Bauteile im vierten Schritt ist ein wasserverdrängendes Mittel vorgesehen. Dieses ist nach einem weiteren Merkmal der Erfindung ein von halogenierten Kohlenwasserstoffen und Aromaten freies Gemisch, welches neben dem Wasserverdränger (Sulfosuccinat) überwiegend aus Isoparaffinen besteht.

Bevorzugt ist die zur Trockung vorgesehene Luft 50° C warm.

Ferner ist vorgesehen, daß die Bauteile nach der Behandlung mit dem Korrosionsschutzmittel getrocknet werden. Hierdurch wird die Bildung eines geschlossenen Oberflächenfilmes erreicht.

Zur Ausübung dieses Verfahrens ist nach einem wesentlichen Merkmal der Erfindung die Verwendung eines Korrosionsschutzmittels vorgesehen, das aus einem Gemisch aus paraffinischen, naphthenischen Kohlenwasserstoffen mit einem Aromatengehalt kleiner 0,5 Gewichtsprozent sowie in paraffinischem Mineralöl gelösten Korrosionsinhibitoren besteht.

Dabei sind ferner als Korrosionsinhibitoren Fettsäureester des Sorbinalkohols (2,4 Hexadien - 1 - ol) unter Zusatz von nicht halogenierten Kohlenwasserstoffen vorgesehen.

Der in diesem Mittel enthaltene Inhibitor gewährleistet, daß nach dem Verdampfen der Lösemittelanteile eine hydrophobe, elektrisch nicht leitende Schicht auf der Metalloberfläche gebildet wird. Voraussetzung für die Erzielung eines solchen wirksamen Schutzes mit dem nach der Erfindung vorgesehenen Korrosionsschutzmittel ist jedoch, daß die Bauteile im Sinne des erfindungsgemäßen Verfahrens behandelt werden.

Ein bevorzugtes Anwendungsgebiet für das erfindungsgemäße Verfahren ist hochwertige Elektronik, insbesondere in Luftfahrtgeräten, aber auch in Waffensystemen, welche auch unter extremen Einsatzbedingungen über einen langen Zeitraum ohne Wartung kostengünstig und frei von Fehlfunktionen betrieben werden müssen.

Von Vorteil bei der Ausübung des erfindungsgemäßen Verfahrens ist, daß eine Umweltverträglichkeit gewährleistet ist. Es werden nämlich keine die Umwelt belastenden, gesundheitsschädlichen oder gesundheitsbeeinträchtigenden Mittel verwendet.
Das verwendete Reinigungsmittel (Lixton-Konzentrat) ist im unbelasteten Zustand biologisch abbaubar und kann als Abwasser entsorgt werden. Je nach aufgenommener Belastung sind die jeweils örtlich geltenden Vorschriften für die Abwasserbehandlung zu beachten.

Eine bevorzugte Anwendung ist nachfolgend beschrieben:

Hohlleiter oder Drahtwickelverbindungen, wie sie beispielsweise in elektronischen Steuerungs- und Schalteinrichtungen von Luftwaffengeräten verwendet werden, werden zunächst mit einem mit Wasser verdünnten Reinigungsmittel, welches beispielsweise handelsüblich unter der Bezeichung Lixton-Konzentrat bezogen werden kann, im Tauchbad zwecks An- oder sogar Ablösung der Verunreinigungen behandelt. Dabei wird das Konzentrat, z.B. im Verhältnis 1:5, in Wasser verdünnt. Der Anlöseprozeß findet bevorzugt bei einer Tauchbadtemperatur von ca. 38 bis 40 Grad Celsius statt. Dabei verbleiben die Bauteile etwa für einen Zeitanteil von 35-40 Minuten in diesem Tauchbad. Anschließend erfolgt ein Abspülen oder Klarspülen mit kaltem bis lauwarmen Wasser. Zur Beseitigung des Wassers werden die Bauteile mit Druckluft von etwa 4 bar abgeblasen. Danach erfolgt ein Waschen und Absprühen, inbesondere mit Druck, mit einem Mittel, das wasserverdrängende Eigenschaften aufweist. Als ein wasserverdrängendes Mittel wird bevorzugt ein von halogenierten Kohlenwasserstoffen freies Mittel verwendet, das überwiegend ein synthetisches Isoparaffin-Gemisch ist, und das ferner Verschnittmittel und Benetzer im geringen Maße aufweist. Anschließend wird ein Trockenvorgang in Luft angeschlossen, welcher etwa zwischen 15-30 Minuten dauert und wobei die Luft etwa 55 °C warm ist. Hierdurch ist es möglich, daß für die Reinigung ein wäßriges Reinigungsmittel eingesetzt werden kann, ohne daß schädliche Einflüsse auf die Funktion der elektronischen bzw. elektromechanischen Bauteile entstehen.

Schließlich werden die metallischen Bauteile durch Aufsprühen des erfindungsgemäßen Korrosionsschutzmittels behandelt, welchem ein weiterer Trockenvorgang im Luftstrom nachgeschaltet ist. Die von fett- und wasserlöslichen Stoffen gereinigte Oberfläche wird dabei mit einer Mischung aus unpolaren Lösemitteln und einem Inhibitor behandelt. Nach Verdampfen der Lösemittelanteile überzieht der Inhibitor die Oberfläche mit einer hyrophoben, elektrisch nicht leitenden Schicht. Beim Inhibitoranteil der Mischung handelt es sich um Ester des Alkohols 2,4-Hexadien-1-ol mit Dodecancarbonsäure, Octadecancarbonsäure, cis-9-Octadecencarbonsäure und trans-Octadecencarbonsäure, jeweils zu gleichen Volumenanteilen.

Die Bestandteile des Korrosionsschutzmittels sorgen dafür, daß ein geschlossener Schutzfilm erzeugt wird. Dieser verhindert, daß die sich in der zur Kühlung der elektronischen Bauteile vorgesehenen Luft befindlichen Schmutzpartikel zur Korrosion der metallischen Bauteile führen können. Es wird ein dauerhafter Schutzfilm erzeugt, so daß die Nutzungsdauer der elektronischen Bauteile insgesamt verlängert wird. Darüber hinaus werden die Reinigungsabstände vergrößert. Schließlich wird auf Dauer eine störungsfreie Funktion der Bauteile erreicht. Eine störungsfreie Funktion ist vor allen Dingen bei solchen Elektronikbauteilen erforderlich, die unter extremen Bedingungen ihre Funktionsfähigkeit behalten müssen und eine möglichst lange Einsatzdauer gewährleisten sollen.

Es ist möglich, dem zweiten Schritt zunächst eine Behandlung mit einem Korrosionsentferner auf der Basis wasserverdünnter Phosphorsäure und danach einen Waschvorgang mit Wasser anzuschließen. Dies ist aber nur erforderlich, wenn eine Sichtkontrolle zeigt, daß Korrosionsbestandteile noch nicht abgelöst sind.

## Patentansprüche

1. Verfahren zum Behandeln benutzter und verunreinigter elektronischer und elektromechanischer Bauteile, insbesondere deren metallischer Komponenten, wobei die Verunreinigungen der Bauteile in einem Tauchbad durch ein wäßriges Reinigungsmittel zumindest angelöst werden,
dadurch gekennzeichnet, daß die Bauteile in einem zweiten Schritt mit Wasser abgespült und danach in einem dritten Schritt mit Luft, insbesondere Druckluft, abgeblasen werden, daß in einem vierten Schritt die Bauteile mit einem wasserverdrängenden Mittel behandelt, insbesondere mit Druck abgesprüht oder getaucht werden, und anschließend die Bauteile in einem fünften Schritt im warmen Luftstrom getrocknet werden, und daß danach in einem sechsten Schritt auf die metallischen Bauteile ein Korrosionsschutzmittel, bestehend aus einem Gemisch aus paraffinischen, naphthenischen, nicht-halogenierten Kohlenwasserstoffen mit einem Aromatengehalt kleiner 0,5 Gew.-% sowie in paraffinischen Mineralölen gelösten Korrosionsinhibitoren, ausgewählt aus Fettsäureestern des Sorbinalkohols (2,4-Hexadien-1-ol), durch Tauchen, Sprühen oder Auftragen aufgebracht wird.

2. Verfahren nach Anspruch 1, dadurch gekennzeichnet, daß nach dem zweiten Schritt, jedoch vor dem Abblasen mit Luft, die Bauteile zunächst mit einem Korrosionsentferner, insbesondere auf der Basis wasserverdünnter Phosphorsäure, gezielt benetzt und anschließend mit Wasser abgewaschen werden.

3. Verfahren nach Anspruch 1, dadurch gekennzeichnet, daß die Bauteile nach dem Auftragen des Korrosionsschutzmittels im Luftstrom getrocknet werden.

4. Verfahren nach Anspruch 1, dadurch gekennzeichnet, daß das wasserverdrängende Mittel ein von halogenierten Kohlenwasserstoffen und Aromaten freies Gemisch ist und dieses neben dem Wasserverdränger überwiegend aus Isoparaffinen besteht.

5. Verfahren nach Anspruch 1 oder 3, dadurch gekennzeichnet, daß die Luft zur Trocknung 50 °C warm ist.

## Claims

1. A process for treating used and soiled electronic and electromechanical components, more particularly metallic parts thereof, the soil present on the components being at least partly dissolved in a dip bath containing a water-based cleaning preparation, characterized in that the components are rinsed with water in a second step and then blasted with air, particularly compressed air, in a third step; in that the components are treated, more particularly by spraying under pressure or immersion, with a water-displacing medium in a fourth step and are dried in a warm air stream in a fifth step; and in that a corrosion inhibitor consisting of a mixture of paraffinic, naphthenic non-halogenated hydrocarbons containing less than 0.5% by weight aromatic hydrocarbons and corrosion inhibitors - dissolved in paraffinic mineral oils - selected from fatty acid esters of sorbic alcohol (1,4-hexadien-1-ol) is applied to the metallic components by dipping, spraying or coating in a sixth step.

2. A process as claimed in claim 1, characterized in that, after the second step, but before blasting with air, the components are first selectively wetted with a corrosion remover, more particularly based on water-diluted phosphoric acid, and then washed with water.

3. A process as claimed in claim 1, characterized in that, after application of the corrosion inhibitor, the components are dried in an air stream.

4. A process as claimed in claim 1, characterized in that the water-displacing medium is a mixture which is free from halogenated hydrocarbons and aromatic hydrocarbons and which, apart from the water displacer, consists predominantly of isoparaffins.

5. A process as claimed in claim 1 or 3, characterized in that the air used for drying has a temperature of 50°C.

## Revendications

1. Procédé de traitement de pièces électroniques et électromécaniques utilisées et souillées, en particulier de leurs composants métalliques, dans lequel les souillures des pièces sont attaquées superficiellement dans un bain d'immersion par un agent de nettoyage aqueux au moins, caractérisé en ce que l'on rince dans une deuxième étape les pièces avec de l'eau, et qu'ensuite l'on souffle dans une troisième étape avec de l'air, en particulier de l'air comprimé, en ce que dans une quatrième étape on traite les pièces avec un agent qui repousse l'eau, que l'on pulvérise en particulier sous pression ou que l'on applique par immersion et qu'ensuite on sèche les pièces dans une cinquième étape dans un courant d'air chaud et en ce qu'ensuite dans une sixième étape, on applique sur les pièces métalliques un agent de protection contre la corrosion constitué d'un mélange d'hydrocarbures paraffiniques, naphténiques, non halogénés ayant une teneur en aromatiques plus faible que 0,5 % en poids ainsi que d'inhibiteurs de corrosion dissouts dans des huiles minérales paraffiniques choisis parmi les esters d'acides gras de l'alcool sorbinique (2,4-hexadien-1-ol) par immersion, pulvérisation ou enduction.

2. Procédé selon la revendication 1, caractérisé en ce qu'après la deuxième étape mais cependant avant le soufflage avec de l'air, les pièces sont humidifiées en premier lieu avec un agent d'élimination de la corrosion, en particulier à base d'acide phosphorique dilué à l'eau et ensuite sont lavées à l'eau.

3. Procédé selon la revendication 1, caractérisé en ce que les pièces sont séchées dans le courant d'air après l'application de l'agent de protection contre la corrosion.

4. Procédé selon la revendication 1, caractérisé en ce que l'agent qui repousse l'eau est un mélange dépourvu d'hydrocarbures halogénés et d'aromatiques et que celui-ci se compose, à côté de l'agent qui repousse l'eau, principalement d'isoparaffines.

5. Procédé selon la revendication 1 ou 3, caractérisé en ce que l'air pour le séchage est chaud à 50°C.
